## Europäisches Patentamt
## European Patent Office
## Office européen des brevets

(19)

(11) Numéro de publication: **0 129 490**
**B1**

(12) **FASCICULE DE BREVET EUROPÉEN**

(45) Date de publication du fascicule du brevet: **10.05.89**

(51) Int. Cl.⁴: **H 05 H 1/18**, H 05 H 1/11, H 01 J 37/32

(21) Numéro de dépôt: **84420103.8**

(22) Date de dépôt: **14.06.84**

(54) Procédé et dispositif de production d'un plasma de grand volume homogène, de grande densité et de faible température électronique.

(30) Priorité: 15.06.83 FR 8310116
15.06.83 FR 8310117

(43) Date de publication de la demande:
**27.12.84 Bulletin 84/52**

(45) Mention de la délivrance du brevet:
**10.05.89 Bulletin 89/19**

(84) Etats contractants désignés:
**CH DE GB LI NL**

(56) Documents cité:
FR-A-2 512 623
GB-A-2 069 230
GB-A-2 076 587
US-A-3 643 123

PLASMA PHYSICS, vol. 15, no. 10, octobre 1973, Pergamon Press, Oxford (GB). A. GOEDE et al.: "Properties of an extremely quiescent plasma stabilized with permanent magnets", pages 977-993
REVIEW OF SCIENTIFIC INSTRUMENTS, vol. 54, no. 1, janvier 1983, American Institute of Physics, New York (US). K.N. LEUNG et al.: "Extraction of volume-produced H-ions from a multicusp source", pages 56-61
JOURNAL OF APPLIED PHYSICS, vol. 47, no. 3, mars 1976, American Institute of Physics, New York (US). R.W. SCHUMACHER et al.: "Characteristics of a large-volume rf-grid discharge plasma", page 886-893
JOURNAL OF APPLIED PHYSICS, vol. 53, no. 6, juin

(73) Titulaire: **CENTRE NATIONAL DE LA RECHERCHE SCIENTIFIQUE (CNRS), 15, Quai Anatole France, F-75007 Paris (FR)**
Titulaire: **ETAT FRANCAIS représenté par le Ministre des PTT (Centre National d'Etudes des Télécommunications), 38- 40 rue du Général Leclerc, F-92131 Issy- les- Moulineaux (FR)**

(72) Inventeur: **Arnal, Yves, 24, avenue de la République, F-38320 Eybens (FR)**
Inventeur: **Pelletier, Jacques, Le Mûrier, F-38400 St-Martin d'Heres (FR)**
Inventeur: **Pomot, Claude, 6, chemin de la Vierge Noire, F-38700 La Tronche (FR)**

(74) Mandataire: **Ropital- Bonvarlet, Claude, Cabinet BEAU DE LOMENIE 99, Grande rue de la Guillotière, F-69007 Lyon (FR)**

(56) Documents cité: (suite)
1982, American Institute of Physics, New York (US). NOAH HERSHKOWITZ et al.: "Electrostatic plugging of leaks in a multidipole device", pages 4105-4112
REVIEW OF SCIENTIFIC INSTR., vol. 44, no. 6, juin 1973, American Institute of Physics, New York (US). RUDOLF LIMPAECHER et al.: "Magnetic multipole containment of large uniform collisionless quiescent plasmas", pages 726-731

Le dossier contient des informations techniques présentées postérieurement au dépôt de la demande et ne figurant pas dans le présent fascicule.

## Description

La présente invention concerne le domaine de la production de plasma à partir de milieux gazeux de toute nature, en vue d'une utilisation à des fins diverses.

On connaît déjà un certain nombre de moyens pour produire des plasmas à partir de milieux gazeux quelconques.

On connaît, par exemple, un procédé faisant intervenir une décharge continue ou un filament thermoémissif. Ces moyens ne permettent pas d'obtenir un plasma de grand volume homogène et dense. De surcroît, dans le cas de mise en oeuvre d'un filament thermoémissif, de tels moyens ne peuvent, généralement, pas être utilisés avec un milieu gazeux réactif par rapport à un tel filament.

On connaît, également, la production de plasma par une décharge radiofréquence. Les mêmes inconvénients que ceux cités ci-dessus doivent être mis au compte de tels moyens techniques, sauf la mise en oeuvre d'un milieu gazeux corrosif qui peut, dans ce cas, être envisagé. Cette méthode présente, de surcroît, l'inconvénient de fournir un plasma de température électronique élevée. Par ailleurs, cette méthode ne permet pas de disposer de paramètres indépendants pour la génération du plasma et pour son utilisation.

On connaît encore la production de plasma au moyen d'ondes hyperfréquences (voir, par exemple, la publication Plasma Physics, vol. 15, n° 10, Oct. 1973, pages 977 à 993). Les plasmas obtenus possèdent une température électronique inférieure à celle des plasmas obtenus par excitation radiofréquence, mais ne sont toujours pas homogènes et de grand volume. Cette méthode présente, cependant, l'avantage de rendre indépendants les paramètres de génération du plasma de ceux de son utilisation.

On connaît, également, la production d'un plasma excité par un filament thermoémissif et maintenu spatialement par un confinement magnétique multipolaire, comme cela est divulgué par la publication Review of Scientific Instruments, vol. 44, n° 6, June 1973, pages 726 à 730. Une telle méthode permet obtention d'un plasma de grand volume homogène, de forte densité, de faible température électronique avec indépendance des paramètres de génération du plasma de ceux de son utilisation.

Cependant, une telle méthode connaît des inconvénients importants tenant, notamment, à la fiabilité dans le temps du filament émissif et à la pollution du milieu ambiant dont il est responsable.

Par ailleurs, le rayonnement thermique du filament est néfaste au déroulement stable du processus de formation du plasma et implique pour chaque phase de génération un temps de montée en température.

En outre, il est exclu, compte tenu de la présence du filament thermoémissif, de pouvoir utiliser une telle méthode dans le cas d'ionisation d'un milieu gazeux à caractère réactif par rapport à la matière constitutive du filament.

On a proposé, aussi, de produire un plasma excité par un filament thermoémissif maintenu par un confinement électrostatique. En plus des inconvénients ci-dessus qui subsistent, il faut noter qu'une telle méthode ne permet pas l'obtention d'un plasma de grand volume homogène.

Les moyens connus ci-dessus ne donnent donc pas satisfaction car, de plus en plus, la technique moderne ressent la nécessité de pouvoir disposer, dans des domaines d'application très divers, de plasmas de grand volume homogène, denses, de faible température électronique, produits à partir d'un milieu gazeux réactif ou non et dont les paramètres de génération sont indépendants de ceux de son utilisation.

Ceci est le cas, notamment, dans les domaines où il est nécessaire de produire, à un coût relativement bas, des ions positifs ou négatifs ou, encore, lorsqu'il s'agit de réaliser une gravure, un dépôt ou une oxydation.

Ceci est en particulier le cas, dans le cadre d'une application préférée de la présente invention, consistant à traiter en surface des substrats divers dans l'industrie de la microélectronique. Dans un tel domaine, il est en effet nécessaire de pouvoir intervenir avec précision et en mettant en oeuvre des énergies les plus faibles possibles, sur des couches de faibles épaisseurs dans lesquelles, par exemple, une action de gravure anisotrope doit être conduite avec précision.

L'objet de l'invention est, justement, de remédier à la carence de la technique antérieure en proposant un nouveau procédé et un nouveau dispositif permettant de produire un plasma continu, de grand volume homogène, de grande densité et de faible température électronique, à partir d'un milieu gazeux réactif ou non.

Un autre objet de l'invention est de proposer un nouveau procédé et un nouveau dispositif permettant l'obtention d'un plasma dont les paramètres régissant sa création ou génération sont indépendants totalement de ceux concernant l'interaction entre ce plasma et c'application qui en est faite.

Les buts ci-dessus sont atteints en employant un procédé selon la revendication 1.

L'invention vise, également, un dispositif selon la revendication 2.

Diverses autres caractéristiques ressortent de la description faite ci-dessous en référence aux dessins annexés qui montrent, à titre d'exemples non limitatifs, des formes de réalisation de l'objet de l'invention.

La fig. 1 est une vue schématique d'un dispositif conforme à l'invention pour la production d'un plasma de grand volume homogène.

La fig. 2 est une perspective partielle illustrant la construction de l'un des éléments constitutifs du dispositif.

La fig. 3 est une perspective partielle, à plus grande échelle, d'un élément constitutif de l'objet de l'invention.

La fig. 4 est une perspective analogue à la fig. 3 mais montrant une variante de réalisation.

Selon le procédé de l'invention, la production d'un plasma de grand volume homogène, de grande densité et de faible température électronique et dont les paramètres régissant sa création ou sa génération sont indépendants de ceux régissant son utilisation ultérieure, consiste à introduire dans une enceinte étanche un milieu gazeux de toute nature choisie en fonction de l'application ultérieure définie. Ce milieu gazeux est maintenu dans l'enceinte sous une pression absolue, par exemple comprise entre quelques $1,2 \times 10^{-3}$ et quelques 13 Pascal ($10^{-5}$ et $10^{-1}$ Torr).

Le milieu gazeux utilisé est introduit dans l'enceinte, de façon continue, de manière à remplir cette dernière à partir de laquelle il peut être extrait par des moyens de pompage appropriés.

A l'intérieur de l'enceinte, le milieu gazeux est ionisé par l'intermédiaire d'ondes hyperfréquences délivrées par un générateur approprié. Les ondes hyperfréquences utilisées sont comprises dans la gamme de 1 à 10 gigahertz et sont, de préférence, voisines de 2,5 gigahertz.

Le plasma produit dans l'enceinte par ondes hyperfréquences est confiné au moins magnétiquement, de façon passive, par une enveloppe multipolaire, de préférence formée à l'intérieur de l'enceinte et autorisant une communication avec les moyens d'amenée et de pompage du fluide gazeux.

De cette manière, il devient possible de produire avec une excellente fiabilité un plasma dense d'environ $10^{11}$ cm$^{-3}$, de température électronique peu différente de 1 électronvolt, parfaitement homogène, dépourvu de champ interne et capable d'occuper un grand volume, par exemple de plusieurs centaines de litres, délimité par l'enveloppe de confinement magnétique multipolaire.

Ce procédé permet, en outre, en raison de l'absence de filament thermoémissif, d'ioniser un milieu gazeux réactif au sens général du terme, c'est-à-dire présentant un caractère de réaction par rapport à une matière quelconque qui serait exposée à l'action de ce plasma.

Ainsi, il devient possible d'utiliser de tels plasmas pour agir en surface sur des substrats divers, pouvant être exposés en faible ou grande surface propre à l'intérieur de l'enveloppe de confinement délimitée à l'intérieur de l'enceinte.

Cet avantage est particulièrement appréciable dans le cas d'application en microélectronique, car la grande densité, le volume important, l'homogénéité ou isotropie du plasma et l'indépendance des paramètres de création du plasma permettent d'effectuer des dépôts, oxydations ou, encore, des gravures de façon précise. Ces traitements peuvent être conduits sur des grandes surfaces en ne faisant intervenir qu'un faible niveau d'énergie, tout en permettant d'obtenir, dans le cas de gravure, une action anisotrope selon la direction d'un champ de déplacement imprimé par l'application d'un potentiel approprié aux substrats.

Dans un autre domaine d'application, il peut être prévu de fermer l'enveloppe de confinement sur une partie au moins de sa périphérie par une grille d'extraction permettant de produire, à partir du plasma créé, des ions positifs ou négatifs, en grande quantité, pouvant alors être concentrés et accélérés en fonction de l'application visée.

Selon le procédé de l'invention, il peut être prévu de diviser l'enveloppe de confinement par un filtre magnétique, de manière à disposer d'une partie de création du plasma, ainsi que d'une partie d'utilisation dans laquelle ledit plasma présente une température électronique inférieure encore.

Dans certains cas, le procédé peut aussi consister à placer l'enveloppe de confinement magnétique multipolaire à l'extérieur de l'enceinte.

Dans le cas de mise en oeuvre d'une enveloppe de confinement interne à l'enceinte, il peut être prévu de lui adjoindre des moyens de confinement électrostatique permettant de diminuer la température électronique d'un facteur de l'ordre de 2 ou, aux fortes pressions, d'augmenter la densité du plasma d'un facteur de l'ordre de 5.

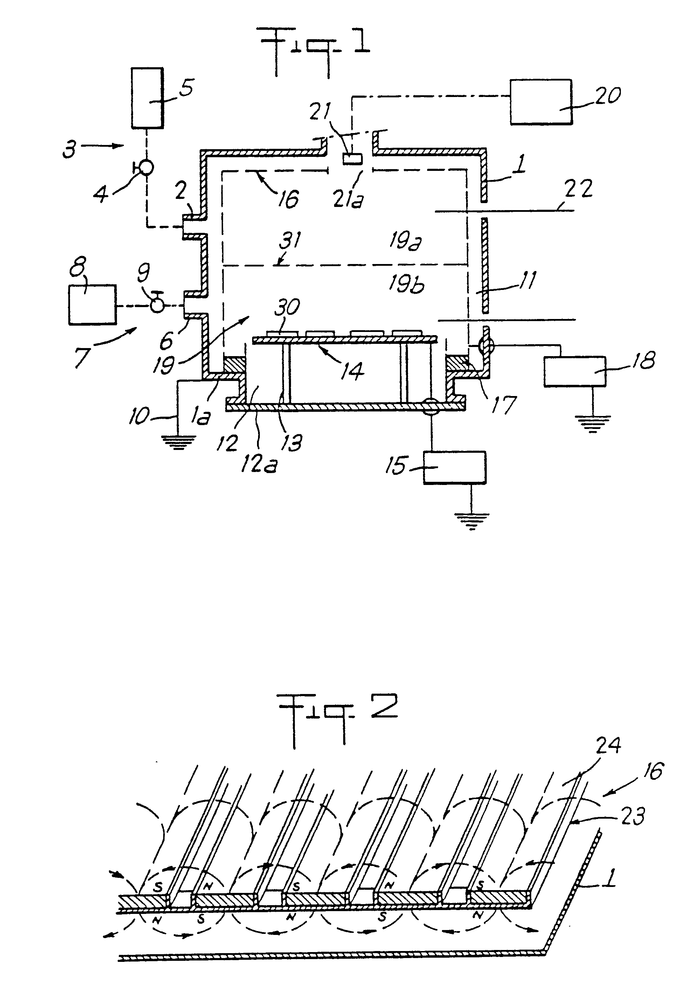

La fig. 1 montre, de façon schématique, une installation ou un dispositif permettant la production d'un plasma de grand volume homogène, de grande densité et de faible température électronique.

Cette installation comprend une enceinte 1, de préférence en un matériau amagnétique, reliée par une tubulure 2 à des moyens 3 de distribution d'un fluide gazeux approprié délivré par une vanne 4 à partir d'un réservoir de stockage 5. L'enceinte 1 est, également, reliée par une tubulure 6 à des moyens 7 de pompage comprenant une pompe 8 et une vanne de réglage de débit 9.

Pour créer un plasma à l'intérieur de l'enceinte 1, le fluide gazeux est entretenu à une pression absolue de l'ordre de $1,3 \times 10^{-3}$ à 13 Pascal ($10^{-5}$ à $10^{-1}$ Torrs). A cette fin, par exemple, les moyens de pompage sont mis en marche pour créer un vide relatif puis les moyens 3 sont réglés pour faire régner la pression absolue désirée.

L'enceinte 1 est reliée à la masse 10 par tout moyen convenable.

Le volume interne 11, délimité par l'enceinte 1, est accessible par une ouverture 12, par exemple ménagée dans la paroi de fond 1a. L'ouverture 12 est, dans le cas présent, fermée par un panneau 12a amovible supportant, par des pieds isolants 13, un portesubstrat 14 qui peut être polarisé de façon continue ou alternative par une source de tension 15 ainsi que thermostaté.

Le volume interne 11 de l'enceinte 1 contient une enveloppe 16 de confinement magnétique constituée par une cage multipolaire qui est maintenue par des supports isolants 17. Cette cage multipolaire peut être mise à la masse ou polarisée par l'intermédiaire d'une source de tension 18. Le porte-substrat 14 est monté de manière à être disposé dans le volume interne 19 de l'enveloppe de confinement magnétique.

L'enceinte 1 est associée à un générateur 20 d'ondes hyperfréquences qui excitent le milieu gazeux, par tout moyen approprié 21, pour produire le plasma qui diffuse à l'intérieur de l'enveloppe 16. Le moyen 21 est, à cet effet, placé en regard d'une fenêtre 21a ménagée dans l'enveloppe 16. Des moyens 22 d'analyse du plasma créé sont adaptés sur l'enceinte 1 qu'ils traversent, de même que l'enveloppe 16. Ces moyens 22 sont, par exemple, constitués par des sondes de LANGMUIR.

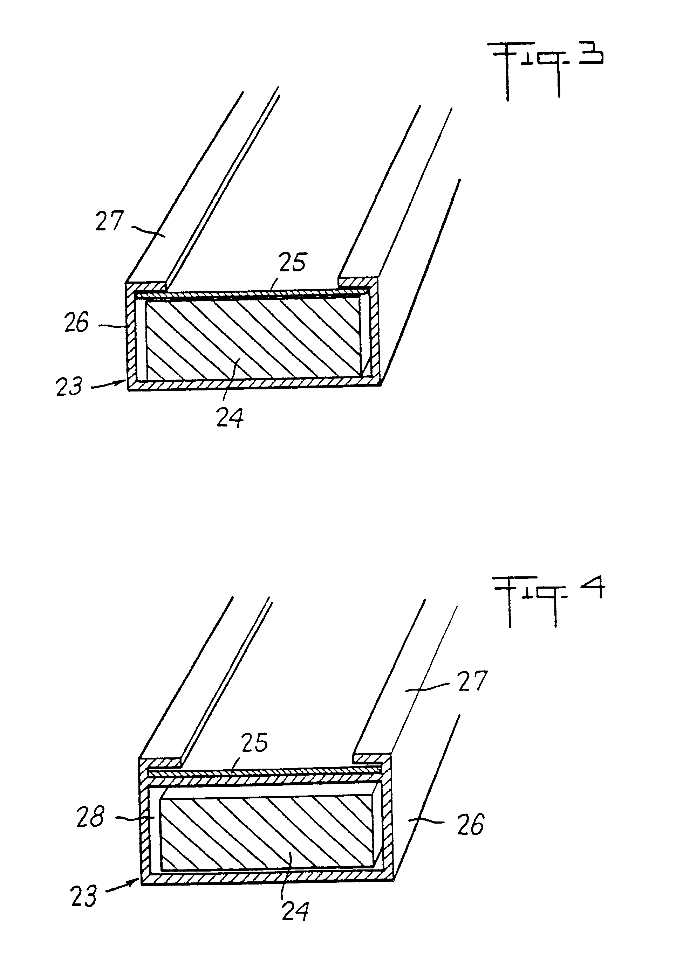

Dans l'exemple illustré, la cage multipolaire est constituée, comme illustré par la fig. 2. Cette cage comprend une armature 23 supportant des barreaux 24 à caractère magnétique permanent. L'armature 23 est conformée de manière à maintenir les barreaux 24 parallèlement entre eux, avec un faible écartement relatif, de façon, en outre, qu'ils présentent chacun, en direction du volume interne défini par la cage multipolaire, une face de polarité successivement différente. Le champ magnétique, ainsi créé entre les barreaux 24 et schématisé par les flèches et les références $\underline{N}$ et $\underline{S}$ à la fig. 2, possède un effet réflecteur pour les électrons du plasma qui est ainsi confiné à l'intérieur du volume 19. L'armature 23 peut être réalisée en toute matière amagnétique et, par exemple, en acier inoxydable.

De façon à limiter la perte d'électrons dans la partie des cônes de perte correspondant aux intersections des lignes de force du champ au droit de chaque barreau 24, il est avantageusement prévu de compléter l'enveloppe de confinement magnétique par des moyens de confinement électrostatique passif. Ces moyens comprennent, par exemple, comme illustré par la fig. 3, une couche 25 de matière isolante recouvrant la face de chaque barreau dirigé vers le volume interne délimité par la cage 16. La couche 25 peut être constituée par une feuille ou une pellicule de matière isolante, telle qu'en mica, capton, etc ... ou, encore, être formée par le dépôt d'une couche de matière isolante en $Al_2O_3$, $TiO_2$, etc ... A cette fin, l'armature 23 délimite des supports 26 profilés à section ouverte, comportant, dans le plan de cette dernière, des rebords 27 de maintien de la feuille ou couche de matière isolante 25.

Dans le cas d'utilisation de fluide gazeux réactif, l'armature 23 peut être constituée, comme illustré par la fig. 4, de manière à comporter, à la place des supports 26, des membrures délimitant des logements étanches 28 dans lesquels sont maintenus et isolés les barreaux 24.

Dans un tel cas, les moyens de confinement électrostatique peuvent être rapportés sur la face de chaque membrure orientée vers le volume interne délimité par la structure 16. Ces moyens peuvent être, comme précédemment, une couche de matériau isolant ou, encore, une plaquette, feuille ou film de matière isolante.

L'association d'un confinement magnétique multipolaire et d'un confinement électrostatique passif permet, toutes choses restant égales par ailleurs, d'augmenter de façon significative la densité d'un plasma et, plus particulièrement, vers les fortes pressions. Une telle augmentation peut être d'un facteur de l'ordre de 2 à 10.

L'association permet aussi de diminuer la température électronique d'un plasma d'un facteur de l'ordre de 2.

L'association permet aussi, avec un milieu gazeux convenable, d'augmenter le taux de production d'ions négatifs.

Dans le cadre d'application dans le domaine de la microélectronique, en vue, par exemple, de produire une gravure, une oxydation ou un dépôt sur des substrats, tels que 30, ces derniers sont montés, fixés, immobilisés de toute façon convenable sur le porte-substrat 14, de manière que la face à traiter soit exposée au plasma créé à l'intérieur du volume 19.

Dans le cas d'application à la production d'ions positifs ou négatifs, l'ouverture 12 est garnie d'une grille convenablement polarisée par la source 15 pour produire l'extraction puis l'accélération éventuelle des ions produits.

La fig. 1 montre qu'il est possible, également, d'améliorer les caractéristiques du plasma produit, notamment en abaissant sa température par l'intermédiaire d'un filtre magnétique 31 associé à l'enveloppe 16, de façon à diviser le volume 19 en une partie 19a de production du plasma et en une partie 19b d'utilisation pour l'exposition, par exemple, des substrats 30. Le filtre magnétique 31 est réalisé d'une façon analogue à ce qui est décrit ci-dessus pour ce qui concerne l'enveloppe de confinement magnétique, sauf à ménager entre les barreaux 24 un intervalle plus grand, de manière à offrir une possibilité accrue de transmission du plasma. Le filtre magnétique peut comporter aussi des moyens de confinement électrostatique, du type de la fig. 3 ou de la fig. 4. Dans tous les cas, le filtre magnétique présente une structure telle que les faces polarisées des barreaux 24 soient parallèles au plan contenant le filtre et orientées vers les deux parties du volume.

L'invention n'est pas limitée aux exemples décrits et représentés, car diverses modifications peuvent y être apportées sans sortir de son cadre.

## Revendications

1. Procédé pour la production d'un plasma dans une enceinte, du type consistant à apporter dans l'enceinte un milieu gazeux entretenu à une pression absolue déterminée, à produire dans l'enceinte des ondes de génération d'un plasma à partir du milieu gazeux et à confiner le plasma dans un volume de l'enceinte par action magnétique multipolaire,

caractérisé en ce que, pour produire un plasma homogène dépourvu de champ interne, de volume pouvant atteindre plusieurs centaines de litres, de densité d'environ $10^{11}$ cm$^{-3}$ et de température électronique pouvant descendre jusqu'à une valeur de l'ordre de 1 eV, il consiste à:

- entretenir dans l'enceinte un milieu gazeux sous une pression absolue comprise entre 1,3 x $10^{-3}$ et 13 Pascal,

- confiner le plasma dans un volume utile par une cage magnétique multipolaire interne à l'enceinte, les parois de cette cage définissant ledit volume utile,

- générer le plasma par un générateur d'ondes hyperfréquences produites dans l'enceinte et hors dudit volume utile, de manière que le plasma diffuse dans ce volume.

2. Dispositif pour la production d'un plasma, du type comprenant une enceinte étanche (1) raccordée à un circuit de pompage (7) et à un circuit (3) d'apport d'un milieu gazeux, une enveloppe de confinement magnétique multipolaire (16), un générateur (20) de plasma et des moyens (22) d'analyse du plasma,

caractérisé en ce que, pour produire un plasma homogène dépourvu de champ interne, de volume pouvant atteindre plusieurs centaines de litres, de densité d'environ $10^{11}$ cm$^{-3}$, de température électronique pouvant descendre jusqu'à une valeur de l'ordre de 1 eV:

- l'enceinte (1) est associée aux moyens de pompage (7) et d'apport (3) entretenant dans l'enceinte une pression absolue comprise entre 1,3 x $10^{-3}$ et 13 Pascal,

- l'enveloppe de confinement est constituée par une cage magnétique multipolaire (16) interne à l'enceinte, formée de barreaux magnétiques, parallèles, offrant, en direction du volume utile que l'enveloppe délimite, une face de polarité successivement différente,

- le générateur (20) est constitué par un générateur d'ondes hyperfréquences associé à un excitateur (21) situé dans l'enceinte et hors du volume utile de l'enveloppe et face à une fenêtre (21a) de l'enveloppe.

3. Dispositif selon la revendication 2, caractérisé en ce que l'enveloppe de confinement est constituée par une cage multipolaire formée par des barreaux (24), à caractère magnétique permanent, portés par une armature amagnétique (23), s'étendant parallèlement entre eux et offrant, en direction du volume que l'enveloppe délimite, une face de polarité successivement différente.

4. Dispositif selon la revendication 2 ou 3, caractérisé en ce que l'enveloppe de confinement comporte des moyens de confinement électrostatique passif comprenant des couches de matière isolante s'étendant devant les faces des barreaux dirigées vers l'intérieur de l'enveloppe.

5. Dispositif selon l'une des revendications 2 à 4, caractérisé en ce que l'enveloppe de confinement magnétique multipolaire est divisée en deux volumes (19a et 19b) par un filtre magnétique (31) constitué de barreaux magnétiques et dont les faces de polarités successivement différentes sont parallèles au plan du filtre et orientées vers les deux parties du volume.

6. Dispositif selon la revendication 5, caractérisé en ce que le filtre magnétique est associé, sur ses deux faces, à des moyens de confinement électrostatique.

## Patentansprüche

1. Verfahren zum Erzeugen eines Plasmas in einem Raum vom Typ bei dem in dem Raum ein gasförmiges Milieu eingebracht wird, das unter einem vorbestimmten absoluten Druck gehalten wird, um in dem Raum Erzeugungswellen eines Plasmas ausgehend von dem gasförmigen Milieu zu erzeugen, und um das Plasma in einem Volumen des Raums durch mehrpolige oder multipolare Magneteinwirkung aneinandergrenzen zu lassen,

dadurch gekennzeichnet, daß zur Erzeugung eines homogenen Plasmas, ausgehend von einem inneren Feld, welches von einem mehrere hundert Liter erreichbaren Volumen ist, mit einer Dichte von ungefähr $10^{11}$ cm$^{-3}$ und einer elektronischen Temperatur, die bis auf einen Wert in der Größenordnung von 1 eV absinken kann, es besteht aus:

- Unterhalten eines gasförmigen Milieus in dem Raum unter einem absoluten Druck zwischen 1,3 x $10^{-3}$ und 13 Pascal,

- Aneinandergrenzen des Plasmas in einem verwenbaren Volumen durch einen mehrpoligen inneren magnetischen Käfig an den Raum, wobei die Seitenwände des Käfigs das verwendbare Volumen definieren,

- Erzeugen des Plasmas durch einen Generator von hochfrequenten Wellen, die in dem Raum und außerhalb des verwendbaren Raums erzeugt werden, derart, daß das Plasma in das Volumen diffundiert.

2. Vorrichtung für die Erzeugung eines Plasmas vom Typ mit einem dichten Raum (1), der mit einem Pumpkreis (7) und mit einem Kreis (3) des Heranbringens eines gasförmigen Milieus verbunden ist, einer Hülle eines mehrpoligen magnetischen Einschlusses (16), einem Plasmagenerator (20) und Plasmaanalyseeinrichtungen (22),

dadurch gekennzeichnet, daß zur Erzeugung eines homogenen Plasmas aus einem inneren Feld stammend mit einem Volumen, welches mehrere hundert Liter erreichen kann, einer Dichte von ungefähr $10^{11}$ cm$^{-3}$, einer elektronischen Temperatur, die auf einen Wert in der Größenordnung von 1 eV absinken kann:

- der Raum (1) mit der Pumpeinrichtung (7) und der Zufuhreinrichtung (3) verbunden ist, die in den Raum einen absoluten Druck von zwischen 1,3 x 10-3 und 13 Pascal einführt,

- die Umhüllung zur Aneinandergrenzung aus einem mehrpolaren oder -poligen magnetischen Käfig (16) innerhalb des Raumes gebildet ist, welcher aus parallelen magnetischen Stäben gebildet ist, die in Richtung des von der Umhüllung gebildeten verwendbaren Volumens eine Seite einer sukzessiv sich ändernden Polarität bieten,

- der Generator (20) aus einem Generator hochfrequenter Wellen gebildet ist, der mit einem Erreger (21) verbunden ist, der in dem Raum und außerhalb des verwendbaren Volumens der Umhüllung und gegenüber einem Fenster (21a) der Umhüllumg angeordnet ist.

3. Vorrichtung nach Anspruch 2, dadurch gekennzeichnet, daß die Angrenzungsumhüllung aus einem mehrpoligen Käfig gebildet ist, der aus permanentmagnetischen Stäben gebildet ist, die von einer nichtmagnetischen Armatur (23) getragen werden, wobei sie sich untereinander parallel erstrecken und in Richtung des Volumens, das die Umhüllung definiert, eine Seite oder Fläche von sukzessiv unterschiedlicher Polarität bieten.

4. Vorrichtung nach Anspruch 2 oder 3, dadurch gekennzeichnet, daß die Umhüllung der Aneinandergrenzung Einrichtungen der passiven elektrostatischen Aneinandergrenzung aufweisen, die Schichten aus isolierendem Material aufweisen, die sich vor den Seiten der Stäbe erstrecken, die in das Innere der Umhüllung gerichtet sind.

5. Vorrichtung nach einem der Ansprüche 2 bis 4, dadurch gekennzeichnet, daß die mehrpolige magnetische Umhüllung der Aneinandergrenzung in zwei Volumen (19a und 19b) durch einen magnetischen Filter (31) geteilt ist, der aus magnetischen Stäben gebildet ist, und deren Flächen aufeinanderfolgender unterschiedlicher Polaritäten in der Ebene des Filters parallel verlaufen und auf die beiden Bereiche des Volumens gerichtet sind.

6. Vorrichtung nach Anspruch 5, dadurch gekennzeichnet, daß der magnetische Filter an seinen beiden Seiten mit Einrichtungen der elektrostatischen Aneinandergrenzung verbunden ist.

**Claims**

1. Process for producing a plasma in an enclosure, of the type consisting in bringing into the enclosure, a gaseous mixture maintained at a predetermined absolute pressure, in producing inside the enclosure waves generating a plasma from the gaseous medium and in confining the plasma within a volume of the enclosure by multipolar magnetic action,

characterized in that, to produce a homogeneous plasma devoid of internal field, of volume which can reach several hundreds of liters, of density about $10^{11}$ cm$^{-3}$ and of electronic temperature which can go down to a value of about 1 eV, it consists in:

- maintaining inside the enclosure a gaseous medium under an absolute pressure of between 1.3 x 10-3 and 13 Pa,

- confining the plasma in a suitable volume by a multipolar magnetic cage internal to the enclosure, the walls of said cage defining said suitable volume,

- generating the plasma by means of UHF waves produced inside the enclosure and outside said suitable volume, so that the plasma diffuses through said volume.

2. Device for producing a plasma, of the type comprising a tight enclosure (1) connected to a pumping circuit (7) and to a circuit (3) supplying a gaseous medium, a multipolar magnetic envelope (16), a plasma generator (20) and means (22) of analyzing the plasma,

characterized in that to produce a homogeneous plasma having no internal field, whose volume can reach several hundreds of liters, of density about $10^{11}$ cm$^{-3}$, of electronic temperature capable of reaching a value of about 1 eV:

- the enclosure (1) is associated to the pumping (7) and supply (3) means maintaining inside the enclosure an absolute pressure of between 1.3 x 10-3 and 13 Pa,

- the confinement shell is constituted by a multipolar magnetic cage (16) internal to the enclosure, formed of parallel magnetic bar, offering, in direction of the suitable volume defined by the envelope, a face of successively different polarity,

- the generator (20) is constituted by a UHF waves generator associated to an exciter (21) situated inside the enclosure and outside the suitable volume of the envelope and in facing relationship to a window (21a) of the envelope.

3. Device according to claim 2, characterized in that the confinement shell is constituted by a multipolar cage formed by bars (24) of permanent magnetic nature, borne by an amagnetic armature (23), extending parallel between them and offering, in the direction of the volume that the shell defines, a face of successively different polarity.

4. Device according to claim 2 or 3, characterized in that the confinement shell comprises electrostatic confinement means comprising layers of insulating matter extending in front of the faces of the bars directed towards the inside of the shell.

5. Device according to one of claims 2 to 4, characterized in that the multipolar magnetic confinement shell is divided into two volumes (19a and 19b) by a magentic filter (31) constituted of magnetic bars and of which the faces of successively different polarity are parallel to the plane of the filter and oriented towards the two parts of the volume.

6. Device according to claim 5, characterized in that the magnetic filter is associated, on its two faces, to electrostatic confinement means.

Fig. 1

Fig. 2

1

Fig. 3

Fig. 4